# EUROPEAN PATENT APPLICATION

(11) **EP 2 604 941 A1**
(43) Date of publication of application: **19.06.2013**
(21) Application number: 11816416.9
(22) Date of filing: 09.08.2011
(51) Int. Cl.: F24F 11/02, F24F 7/06, F24F 11/04, F25B 49/02, G06F 1/20

(54) **APPARATUS FOR OPERATION OF COOLING SYSTEM IN ABNORMAL STATE**

(30) Priority: 10.08.2010 JP 2010179625
(71) Applicant: Hitachi Plant Technologies, Ltd., Tokyo 170-8466 (JP); Hitachi, Ltd., Chiyoda-ku Tokyo 100-8280 (JP)
(72) Inventor: KASHIRAJIMA, Yasuhiro, Tokyo 170-8466 (JP); ITO, Junichi, Tokyo 170-8466 (JP); YOSHIDA, Tomohiro, Tokyo 170-8466 (JP); SENDA, Masakatsu, Tokyo 170-8466 (JP); MIKAMI, Teruo, Tokyo 170-8466 (JP); SAWAMOTO, Hideo, Tokyo, 100-8280 (JP); IDEI, Akio, Tokyo, 100-8280 (JP); KOYANO, Koichi, Tokyo, 100-8280 (JP)
(74) Representative: Beetz & Partner
(86) International application number: PCT/JP2011/068120
(87) International publication number: WO 2012/020752

(57) **Abstract**

Provided is an apparatus for operating a cooling system in an abnormal state, and the cooling system includes plurality of evaporators that suck warm air exhausted from a plurality of electronic equipments installed in an equipment room with fans, cool the warm air through heat exchange with a refrigerant flowing in each cooling coil, and supply cool air into the equipment room; and a condenser disposed at a position higher than the plurality of evaporators, so as to cool the refrigerant circulated naturally between the condenser and each evaporator. The cooling system adjusts a supplied air temperature of air supplied from each evaporator by adjusting an opening degree of each flow regulating valve that adjusts a flow rate of the refrigerant flowing in each cooling coil. The apparatus includes deviation information detecting means for sequentially detecting deviation information between an maximum cooling capacity and a current cooling capacity in operation for each of the plurality of evaporators; and fan controlling means for reducing or stopping a rotational frequency of a fan for an evaporator which has deviation information exceeding a predefined abnormal determining threshold value among the plurality of evaporators.

## Description

### {Technical Field}

The present invention relates to an apparatus for operating a cooling system in an abnormal state, particularly to an apparatus for operating a cooling system in an abnormal state that carries out natural circulation of refrigerant through evaporators and condensers for locally cooling electronic equipment such as computers and severs installed in an equipment room such as a server room.

### {Background Art}

Recently, amount of information required to be processed has been significantly increased in accordance with development of information processing technologies and progress of the Internet environment. Data processing centers for processing tremendous amount of a variety of information attract people's attentions as a business target. Such data processing centers have server rooms where a large number of electronic equipment such as servers is integrally installed, and these servers continuously operate night and day.

Since precise operation is required in servers, a server room where the servers are installed should be maintained in a thermal environment having a temperature in compliance with serviceability standards for the servers. An entire server room is usually cooled by air conditioners so as to cool heat emitted from the servers, so as to maintain the preferable thermal environment for the servers.

Unfortunately, rapid progress of processing speed and processing performance of current servers encourage more increase in calorific values of the servers, so that sufficient cooling of the servers cannot be secured by a cooling system that cools the entire server room only with air conditioners.

From the above background, such cooling systems have been employed that circulate a refrigerant between evaporators and condensers so as to locally cool servers by the evaporators. Specifically, each server has a suction port on its front face and an exhaust port on its back face, and the servers are stacked up in each server rack in the server room, and each of the plural evaporator is disposed between server racks. The intake ports of the evaporators that take in warm air and the exhaust ports of the servers face an identical space side so as to form a warm space, and outlet ports of the evaporators that supply cool air and the suction ports of the servers face another space side so as to form a cooling space.

In the cooling system for locally cooling in which the server racks and the evaporators are arranged in the above manner, the warm air of the servers exhausted from the plural racks into the warm space is sucked into the intake ports of the plurality of evaporators and is cooled, and thereafter, the air is supplied from the outlet ports of the evaporators into the cooling space as cool air.

In the above cooling system, if one of the evaporators has deteriorated cooling capacity, the warm air in the warm space sucked into this evaporator is insufficiently cooled, and is supplied into the cooling space. Consequently, heat of the warm space is recirculated in the cooling space. This results in deterioration of the air conditioning environment due to increase in temperature in the cooling space; therefore, the servers suck warm air from their suction ports, which causes malfunction of the servers.

PTL 1 suggests partition panels stretchable in the vertical direction of racks, so as to prevent heat of a warm space from flowing into a server room and recirculating in a cooling space.

### {Citation List}

### {Patent Literature}

{PTL 1} Japanese Patent Application Laid-Open No. 2010-25451

### {Summary of Invention}

### {Technical Problem}

As suggested by PTL 1, there are provided the partition panels in the vertical direction of the racks so as to prevent the heat of the warm space from flowing into the server room and circulating in the cooling space.

Unfortunately, the above suggestion cannot prevent recirculation of the warm air insufficiently cooled that is supplied from the evaporator at the time of an abnormal operation, which deteriorates the cooling capacity of the evaporators. Consequently, the other normal evaporators are subjected to increase in cooling load, and the thermal environment of the entire equipment room deteriorates with time.

An object of the present invention, which has been made in order to solve the problems according to the conventional art, is to provide an apparatus for operating a cooling system in an abnormal state capable of securely determining an evaporator having abnormality in the cooling capacity among plurality of evaporators, and preventing warm air exhausted from electronic equipment from being recirculated in an equipment room, thereby reducing cooling load of the other evaporators operating normally, and preventing deterioration of the air conditioning environment in the entire equipment room.

### {Solution to Problem}

In order to achieve the above object, there is provided an apparatus for operating a cooling system in an abnormal state, wherein the cooling system including: a plurality of evaporators that suck warm air exhausted from a plurality of electronic equipment installed in an equipment room with fans, cool the warm air through heat exchange with a refrigerant flowing in a cooling coil, and supply cool air into the equipment room; and a condenser disposed at a position higher than the plurality of evaporators, the condenser which cools the refrigerant circulated naturally between the condenser and each evaporator, the cooling system which adjusts a supplied air temperature of air supplied from each evaporator by adjusting an opening degree of each flow regulating valve that regulates a flow rate of the refrigerant flowing in the cooling coil, wherein the apparatus comprising: deviation information detecting means for sequentially detecting deviation information between an maximum cooling capacity and a current cooling capacity in operation for each of the plurality of evaporators; and fan controlling means for reducing or stopping a rotational frequency of a fan for an evaporator which has deviation information exceeding a predefined abnormal determining threshold value among the plurality of evaporators.

According to the present invention, it is configured to sequentially detect deviation information between the maximum cooling capacity and the current cooling capacity in operation of each of the plural evaporator, and to reduce or stop a rotational frequency of a fan of an evaporator which has the deviation information exceeding a predefined abnormality setting value, among the plurality of evaporators.

In this configuration, if one of the plurality of evaporators is determined to have abnormality, the rotational frequency of the fan of this evaporator is reduced or stopped, for example. Even if the warm air exhausted from the electronic equipment into the equipment room is sucked into the evaporator determined to have abnormality, insufficiently cooled air is prevented from being supplied from this evaporator into the equipment room. Accordingly, the warm air exhausted from the electronic equipment can be prevented from being recirculated in the equipment room, so that abnormality of one evaporator is prevented from affecting the cooling load of the other evaporators operating normally, thereby preventing deterioration of the thermal environment of the entire equipment room.

In the present invention, it is preferable that the fan controlling means reduces the rotational frequency of the fan in accordance with a cooling capacity lowering rate of the evaporator based on the deviation information, and stops the fan if the cooling capacity lowering rate exceeds a threshold value.

By reducing the rotational frequency of the fan of the evaporator in accordance with the cooling capacity lowering rate of this evaporator, the evaporator can be adjusted to take in (suck in) and cool the warm air in accordance with its current cooling capacity for cooling the warm air. Accordingly, even if the evaporator has abnormality, this evaporator can supply the cool air into the cooling space at the same supplied air temperature as that before the abnormality occurs. If the cooling capacity lowering rate is too decreased and exceeds the threshold value, the fan of this evaporator is stopped. Accordingly, the warm air exhausted from the electronic equipment can be prevented from being recirculated in the equipment room. At this time, the threshold value may be set (defined) based on the relation with the reserved cooling capacity of the other evaporators operating normally.

In the present invention, it is preferred that the deviation information detecting means includes: supplied air temperature detecting means for detecting the supplied air temperature; and valve opening degree detecting means for detecting the opening degree of each flow regulating valve, and the fan controlling means reduces or stops the rotational frequency of the fan if the supplied air temperature is equal to or higher than an upper limit of a specification temperature range of the electronic equipment, and if the flow regulating valve has an approximate maximum opening degree.

Here, the approximate maximum opening degree of the flow regulating valve denotes a valve opening degree required for securing the maximum cooling capacity of the evaporator, and the valve opening degree of 70% or more may be defined as the approximate maximum opening degree, and more preferably the valve opening degree of 80% or more.

Since it is configured to reduce or stop the rotational frequency of the fans if the supplied air temperature from the evaporator is equal to or higher than an upper limit of the specification temperature range of the electronic equipment, and if the flow regulating valve has the approximate maximum opening degree, it is possible to prevent the normal operation of the evaporator from being misrecognized as the abnormal operation, so as not to lower or stop the rotational frequency of the fans based on this misrecognition. Accordingly, it is possible to precisely detect the lowering of the cooling capacity of the evaporator, and control the rotational frequency of the fans in accordance with its cooling capacity.

Specifically, the cooling system of the present invention adjusts the opening degree of each flow regulating valve for regulating the flow rate of the refrigerant of each evaporator, which flows in each cooling coil, thereby adjusting the temperature of the supplied air supplied from the evaporator, and thus, there is a response lag (time lag) from the adjustment of the valve opening degree until the temperature of the supplied air starts to change. For example, although the cooling capacity of the evaporator is normal, if cooling load of the evaporator due to disturbance (the case of a temporal increase in temperature of the warm air exhausted from the server, for example) becomes increased, the temperature of the supplied air of the evaporator sometimes exceeds the upper limit of the specification temperature range due to the response lag. If the rotational frequency of the fans is controlled only based on the abnormality in the supplied air temperature before the evaporator achieves the maximum cooling capacity, the normal operation of the evaporator may be misrecognized as the abnormal operation, and the rotational frequency of the fans is controlled based on this misrecognition, which hinders a precise detection of the cooling capacity lowering of the evaporator.

In the present invention, it is preferred that the deviation information detecting means further comprises refrigerant temperature detecting means for detecting a temperature of the refrigerant to be supplied to the cooling coil, and that the fan controlling means reduces or stops the rotational frequency of the fan if the supplied air temperature is equal to or higher than the upper limit of the specification temperature range of the electronic equipment, and if the flow regulating valve has the approximate maximum opening degree, and if the refrigerant temperature is equal to or lower than a design temperature for securing the maximum cooling capacity.

Since there is further provided the refrigerant temperature detecting means in addition to the supplied air temperature detecting means and the valve opening degree detecting means, it is possible to more precisely monitor the deterioration of the cooling capacity of the evaporator. Specifically, although the temperature of the supplied air from the evaporator is equal to or higher than the upper limit of the specification temperature range, and the valve opening degree is the approximate maximum opening degree, the condenser is deemed to operate normally for securing the maximum cooling capacity if the refrigerant temperature is equal to or lower than the design temperature. Hence, the lowering of the cooling capacity of the evaporator is considered as a temporal variation due to disturbance or the like; thus, it may rather cause a wrong control if the rotational frequency of the fans is reduced or stopped in response to such disturbance or the like before the evaporator achieves the maximum cooling capacity.

The temperature of the refrigerant is an index to indicate whether or not the cooling system of the natural circulation type operates normally, and the refrigerant temperature detecting means enables monitoring of the entire cooling system of the natural circulation type.

In the present invention, it is preferred that the deviation information detecting means further comprises refrigerant pressure detecting means for detecting pressure of the refrigerant to be supplied to the cooling coil, and that the fan controlling means reduces or stops the rotational frequency of the fan if the supplied air temperature is equal to or higher than the upper limit of the specification temperature range of the electronic equipment, and if the flow regulating valve has the approximate maximum opening degree, and if the refrigerant pressure is equal to or higher than a design pressure for securing the maximum cooling capacity.

In this configuration, the refrigerant temperature detecting means is replaced with the refrigerant pressure detecting means, and they have the same effect.

In the present invention, it is preferred that the deviation information detecting means further comprises intake air temperature detecting means for detecting an intake air temperature of the warm air sucked into the evaporators and that the fan controlling means reduces or stops the rotational frequency of the fan if the supplied air temperature is equal to or higher than the upper limit of the specification temperature range of the electronic equipment, if the flow regulating valve has the approximate maximum opening degree, and if a temperature difference between the intake air temperature and the supplied air temperature is equal to or larger than a design temperature difference for securing the maximum cooling capacity.

In this configuration, since the intake air temperature detecting means is provided in addition to the supplied air temperature detecting means and the valve opening degree detecting means, it is possible to more precisely monitor the deterioration of the cooling capacity of each evaporator. Specifically it is possible to confirm how much the cooling capacity of each evaporator is achieved by monitoring the temperature difference between the intake temperature and the supplied air temperature of each evaporator.

Hence, even when the supplied air temperature is equal to or higher than the upper limit of the specification temperature range and the flow regulating valve has the approximate maximum opening degree, the cooling capacity is sufficient if the temperature difference between the intake temperature and the supplied air temperature is equal to or smaller than the design temperature difference for securing the maximum cooling capacity, and this lowering of the cooling capacity is considered as a temporal variation due to disturbance. Consequently, it may rather cause a wrong control if the rotational frequency of the fans is reduced or stopped before the evaporator achieves the maximum cooling capacity.

In the present invention, it is preferred that the electronic equipment is housed in racks in a stacked state, and each of the racks has suction ports formed at a front face thereof, and exhaust ports formed at a rear face thereof, and the evaporator is disposed between the racks, and the intake ports of the evaporators and the exhaust ports of the racks face an identical space to form a warm space, and outlet ports of the evaporators and suction ports of the racks face another identical space to form a cooling space.

In this arrangement of the racks and the evaporators, if one of the evaporators has deteriorated cooling capacity, the warm air in the warm space is recirculated in the cooling space, and thus the apparatus for an operation in an abnormal state of the present invention is effective particularly in such a situation.

### {Advantageous Effects of Invention}

As described above, the apparatus for operating a cooling system in an abnormal state can securely determine an evaporator having abnormality in the cooling capacity among plurality of evaporators, and prevent warm air exhausted from the electronic equipment from being recirculated in the equipment room, thereby reducing cooling load of the other evaporators operating normally, and preventing deterioration of the air conditioning environment in the entire equipment room.

### {Brief Description of Drawings}

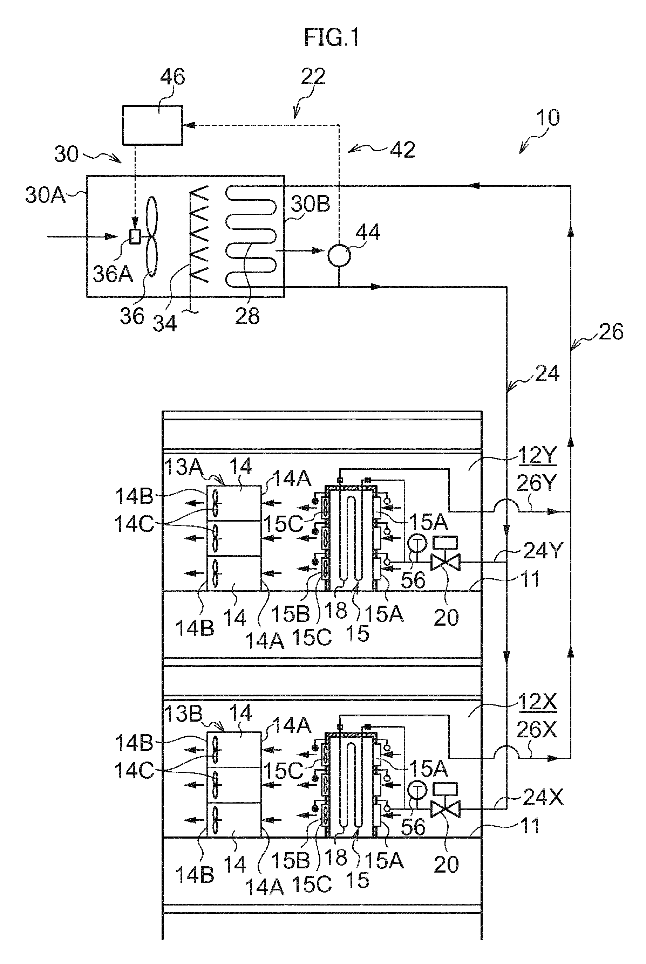

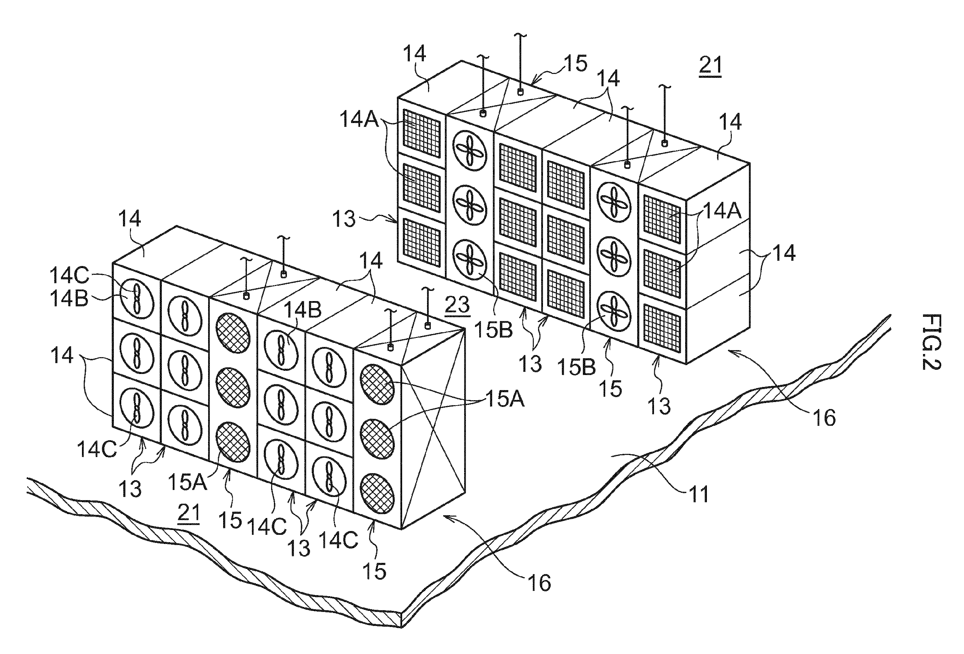

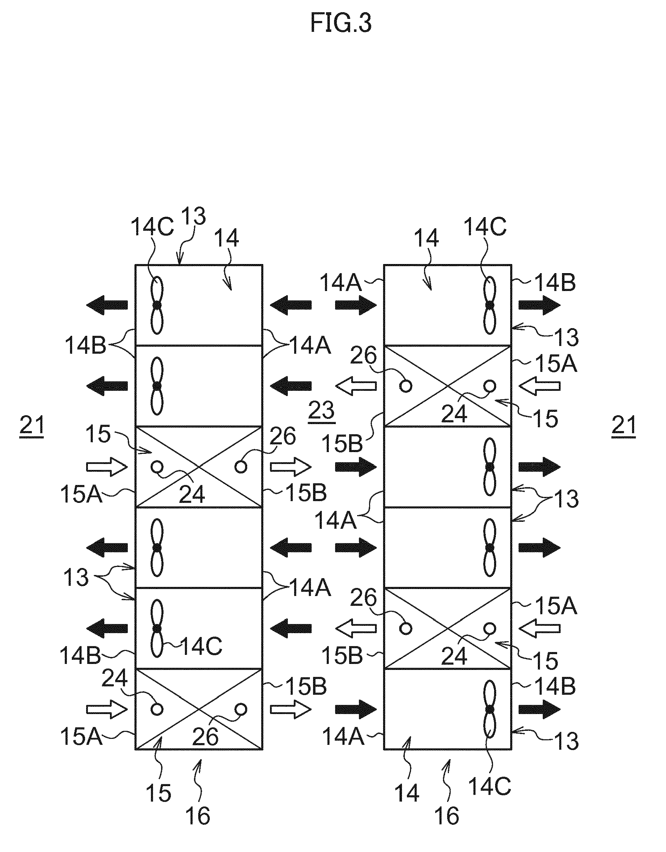

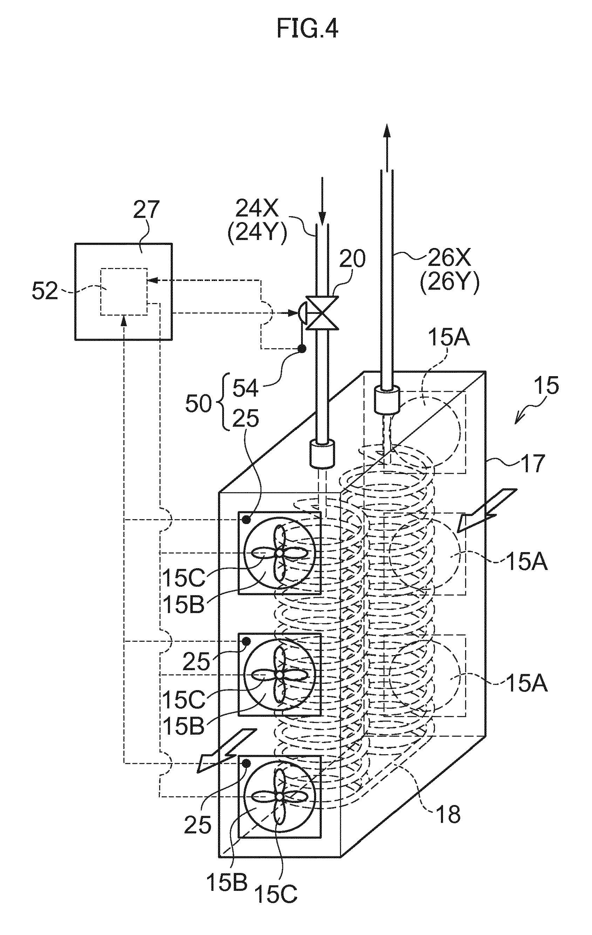

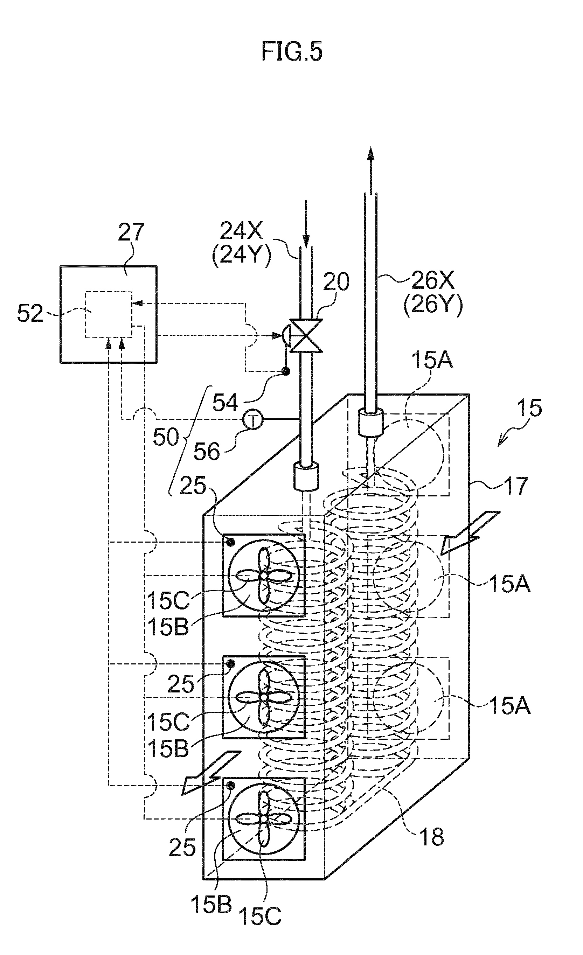

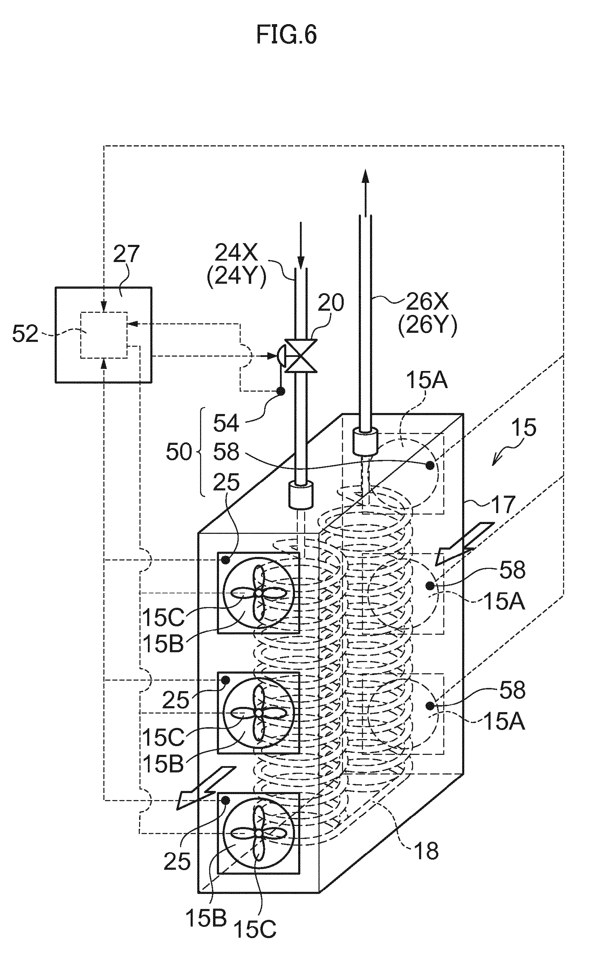

{Figure 1} Figure 1 is a schematic diagram explaining a general configuration of the cooling system of the present invention.
{Figure 2} Figure 2 is a perspective view explaining an arrangement of server racks for housing servers in a stacked manner and an arrangement of evaporators.
{Figure 3} Figure 3 is a plan view of Figure 2.
{Figure 4} Figure 4 is an explanatory diagram explaining a structure of an evaporator and an apparatus for operation in an abnormal state of the first embodiment.
{Figure 5} Figure 5 is an explanatory diagram explaining an apparatus for operation in an abnormal state of the second embodiment.
{Figure 6} Figure 6 is an explanatory diagram explaining an apparatus for operation in an abnormal state the third embodiment.

### {Description of Embodiments}

Hereinafter, detailed description will be provided on the embodiment of the apparatus for operating a cooling system in an abnormal state according to the present invention, with reference to the drawings.

In the present embodiment, severs installed in a server room will be described as an example of electronic equipment.

Figure 1 is schematic diagram showing a general configuration of a cooling system 10 of a natural circulation type in which refrigerant is naturally circulated.

The cooling system 10 shown in the same drawing includes the following components as a system for locally cooling warm air exhausted from servers 14 installed in a server room 12 having two stories of an upper floor and a lower floor. In the following description, a reference character X indicates a component of the cooling system pertinent to a server room 12X of the lower floor, and a reference character Y indicates a component of the cooling system pertinent to a server room 12Y of the upper floor.

Description will be provided on an arrangement of racks 13 housing the servers 14 in a stacked manner and evaporators 15.

As shown in Figure 1, Figure 2 and Figure 3 (see Figure 2 and Figure 3, particularly), plural server racks 13 each of which houses the servers 14 in a vertically stacked manner (three stories, for example) are horizontally arranged in a row on a floor 11 of each server room 12 (12X, 12Y), and plurality of evaporators 15 are disposed between server racks 13. Through this configuration, a unit row 16 in which the server racks 13 and the evaporators 15 are arranged is formed, and plural unit rows 16 are arranged in parallel to each other at predetermined intervals. The installation of the evaporators 15 is not limited to a position between server racks 13, and some of the plurality of evaporators 15 may be disposed at right and left ends of each unit row 16.

Two unit rows 16 are shown in Figure 2 and Figure 3, but a large number of the unit rows 16 are arranged in an actual server room 12. Any number of the server racks 13 and the evaporators 15 may be used.

Each of the servers 14 stacked in each server rack 13 includes a suction port 14A and an exhaust port 14B, and also includes a fan 14C thereinside. This fan 14C is driven so as to take in cool air of the server room 12 from the suction port 14A, and warm air along with waste heat of the server 14 is exhausted from the exhaust port 14B.

The intake ports 15A of the evaporators 15 for taking in the warm air and the exhaust ports 14B of the servers 14 in the same unit row 16 face an identical space so as to form a warm space 21, and the outlet ports 15B of the evaporators 15 for supplying the cool air and the suction ports 14A of the servers 14 in the same unit row 16 face another identical space so as to form a cooling space 23. In Figure 3, white arrows indicate air flows of the evaporators 15, and black arrows indicate air flows of the servers 14.

Description will now be provided on the evaporators 15 and the condensers 22 that are main components of the cooling system.

As shown in Figure 1, each evaporator 15 is connected to a condenser 22 through a fluid pipe 24 that is a flow passage of liquid refrigerant, and through a gas pipe 26 that is a flow passage of gas refrigerant. This configuration forms a circulation passage through which the refrigerant flows between each evaporator 15 and the condenser 22. In the present embodiment, a cooling tower 22 is described as an example of the condenser 22, but a combination of a refrigerator and a heat exchanger may be applicable, instead.

The evaporator 15 is a device for taking the warm air exhausted from the servers 14 into the server room 12, and for cooling the warm air in the evaporator, and then supplies cool air into the server room 12, thereby adjusting the temperature to be acceptable for a specification temperature of the servers 14.

As shown in Figure 4, the intake ports 15A are formed on one side face, and the outlet ports 15B equipped with fans 15C are formed on the other side face of opposed side faces of a casing 17 of each evaporator 15. A plurality (three in the present embodiment) of the intake ports 15A and of the outlet ports 15B are disposed in the vertical direction of the casing 17.

As shown in Figure 4, a cooling coil 18 is disposed within the casing 17. One end of the cooling coil 18 is connected to branched fluid pipes 24X, 24Y that is branched from the above described fluid pipe 24 for respective floors, and the other end thereof is connected to branched gas pipes 26X, 26Y that is branched from the above described gas pipe 26 for respective floors.

As shown in Figure 1, an upper end of the gas pipe 26 is connected to an entry of a heat exchange coil 28 in the cooling tower 22, and an upper end of the fluid pipe 24 is connected to an exit of the heat exchange coil 28 in the cooling tower 22.

Further, as shown in Figure 4, supplied air temperature detecting means 25 is disposed in vicinity of each outlet port 15B of each evaporator 15 so that the supplied air temperature detecting means 25 detects a temperature of the supplied air supplied from each outlet port 15B, and the temperature of the supplied air from each outlet port 15B is sequentially input to controlling means 27. A flow regulating valve 20 for regulating the flow rate of the liquid refrigerant is provided at an entry of each evaporator 15 on the fluid pipe 24 for supplying the liquid refrigerant to the cooling coil 18. The controlling means 27 performs a PID control on an opening degree of each flow regulating valve 20 at every one second interval based on the temperature of the supplied air. At this time, the controlling means 27 uses an average temperature of the supplied air supplied from each outlet port 15B as the supplied air temperature for use in the control. The time interval for controlling the opening degree of the flow regulating valve 20 is not limited to every one second interval, and the control method is not limited to the PID control.

Meanwhile, the cooling tower 22 is a device for cooling and condensing the refrigerant gas vaporized by the evaporator 15, and is located at a position higher than the evaporators 15, such as on a roof of a building of the server room 12.

As shown in Figure 1, in the cooling tower 22, a cooling tower main body (casing) 30 is horizontally arranged, and an inlet port 30A for taking in outside air is disposed at one end of the cooling tower main body 30, and an exhaust port 30B is disposed at the other end of the cooling tower main body 30. A heat exchange coil 28 is disposed within the cooling tower main body 30, an entry of the heat exchange coil 28 is connected to the gas pipe 26 in which the refrigerant gas returning from the evaporator 15 flows as described above, and an exit of the heat exchange coil 28 is connected to the fluid pipe 24 in which the fluid refrigerant to be supplied to the evaporator 15 flows.

In addition, a sprinkler 34 is disposed on a side of the inlet port 30A of the heat exchange coil 28, and a blower fan 36 is disposed on a side of the inlet port 30A of the sprinkler 34. The outside air taken from the inlet port 30A of the cooling tower main body 30 through the blower fan 36 is sent to the heat exchange coil 28, and water is sprinkled from the sprinkler 34 to the heat exchange coil 28. Accordingly, the refrigerant gas flowing in the heat exchange coil 28 is cooled and condensed with the outside air and the sprinkled water, so as to be liquefied into the liquid refrigerant. Meanwhile, the outside air sucked into the cooling tower main body 30 picks up heat from the refrigerant gas flowing in the heat exchange coil 28, so that the temperature of this air is increased, and thereafter this air is exhausted from the exhaust port 30B as the exhaust air.

The cooling tower 22 is provided with cooling tower controlling means 42 for constantly maintaining the temperature of the liquid refrigerant at the exit of the heat exchange coil 28 to be a predetermined value.

The cooling tower controlling means 42 includes a liquid refrigerant temperature sensor 44 for measuring a temperature of the liquid refrigerant at the exit of the heat exchange coil 28, air flow volume adjusting means 36A for adjusting the air flow supplied from the blower fan 36 to the heat exchange coil 28 by varying the rotational frequency of the blower fan 36, and controlling means 46 for controlling the air flow volume adjusting means 36A based on the measured temperature on the liquid refrigerant temperature sensor 44. In the present embodiment, it is configured that the temperature of the liquid refrigerant at the exit of the heat exchange coil 28 is maintained at a predetermined value only by using the cooling tower 22. If it becomes difficult to maintain the temperature of the liquid refrigerant at the exit of the heat exchange coil 28 to be a predetermined value by using the cooling tower 22 alone because the outdoor temperature becomes high in the summer season, for example, a heat exchanger (not shown) is additionally provided in parallel to the cooling tower 22, and primary cooling water to be supplied to the heat exchanger may be cooled by a refrigerator (not shown).

Through the above described configuration of the cooling system 10, the evaporator 15 carries out heat-exchange between the warm air exhausted from the servers 14 and the liquid refrigerant flowing in the cooling coil 18, thereby vaporizing the liquid refrigerant. The vaporized refrigerant gas flows in the gas pipe 26 upward, and is naturally conveyed to the cooling tower 22, and the refrigerant gas is vaporized in the cooling tower 22, and thereafter, liquefied refrigerant flows in the fluid pipe 24 downward, and is naturally conveyed to each evaporator 15 again. In this manner, the natural circulation of the refrigerant is carried out.

In this natural circulation of the refrigerant, the controlling means 27 controls the opening degree of each flow regulating valve 20 provided on the fluid pipe 24 at the entry of each evaporator 15 based on the supplied air temperature detected on each supplied air temperature detecting means 25, so as to regulate the flow rate of the refrigerant to be supplied to the cooling coil 18 of each evaporator 15. In this configuration, the warm air at a high temperature (40°C, for example) exhausted into the warm space 21 from the servers 14 is sucked into each evaporator 15, and is cooled to have a temperature equal to or lower than an upper limit (25°C at most, for example) of a specification temperature range (10 to 30°C, for example) for the servers 14, and is blown out (supplied) to the cooling space 23. Accordingly, the thermal environment of the server room 12 can be adjusted at a temperature preferable to the operation environment of the servers 14. As an example of the refrigerant used in the natural circulation, chlorofluorocarbon, HFC (hydrofluorocarbon) that is an alternative of chlorofluorocarbon, and so on may be preferably used.

Particularly in the case of carrying out local cooling using the warm space 21 and the cooling space 23 formed by the unit row 16, if one of the plurality of evaporators 15 has abnormality in the cooling capacity (deterioration of the cooling capacity), the warm air in the warm space 21 sucked into the evaporator 15 having abnormality cannot be sufficiently cooled, and is supplied into the cooling space 23. This results in recirculating the warm air of the warm space 21 into the cooling space 23. Consequently, the temperature of the cooling space 23 is increased, and the thermal environment becomes deteriorated; thus the servers 14 take in the warm air from the suction ports 14A, which causes malfunction of the servers 14.

As shown in Figure 4, in the present embodiment, the controlling means 27 is provided with a function of the apparatus for an operation in an abnormal state including, in each evaporator, deviation information detecting means 50 that sequentially detects deviation information between the maximum cooling capacity and the current cooling capacity in operation for each of the plurality of evaporators 15, and fan controlling means 52 that reduces or stops the rotational frequency of the fans 15C of an evaporator 15 among the plurality of evaporators 15, which has a value more than an abnormality setting value that is predefined in the deviation information. The fan controlling means 52 is configured to reduce the rotational frequency of the fans 15C depending on the cooling capacity lowering rate of the evaporator 15 detected to have abnormality on the deviation information detecting means 50, or stops these fans 15C if the cooling capacity lowering rate exceeds a threshold value.

In this configuration, if one of the plurality of evaporators 15 is detected to have abnormality in the cooling capacity, the rotational frequency of the fans 15C of the evaporator 15 detected to have abnormality is reduced or stops, so as to prevent the warm air, which is exhausted from the servers 14 and sucked into the evaporator 15 detected to have abnormality, from being supplied into the cooling space 23 without being sufficiently cooled. Accordingly, the warm air exhausted from the servers 14 can be prevented from being recirculated from the warm space 21 into the cooling space 23, thereby reducing cooling load of the other evaporators 15 operating normally, and preventing deterioration of the air conditioning environment of the entire server room 12.

In addition, when the rotational frequency of the fans 15C is reduced based on the cooling capacity lowering rate of the evaporator 15, the evaporator 15 can be adjusted to take in the warm air in accordance with its current cooling capacity for cooling the warm air. Accordingly, even if the evaporator 15 has abnormality, this evaporator 15 can send the cool air into the cooling space 23 at the same supplied air temperature as that before the abnormality occurs. If the cooling capacity lowering rate is too decreased and becomes lower than the threshold value, the fans of the concerned evaporator 15 are stopped. The threshold value may be appropriately defined based on the relation with the reserved cooling capacity of the other evaporators 15 operating normally. Specifically, if the other evaporators 15 operating normally have a great reserved cooling capacity, the threshold value may be defined at a stage where the cooling capacity lowering rate of the evaporator 15 detected to have abnormality is small. If the other evaporators 15 operating normally have a small reserved cooling capacity, the threshold value may be defined at a stage where the cooling capacity lowering rate of the evaporator 15 detected to have abnormality is great because the evaporator 15 detected to have abnormality is even necessary to be used as much as possible.

In the cooling system which includes a compressor and employs forced circulation of the refrigerant, if the rotational frequency of the fans of the concerned evaporator 15 is varied, the compressor should also be adjusted at the same time, otherwise dews may be generated in the concerned evaporator 15; therefore the adjustment of the compressor in accordance with the abnormal detection of the evaporator 15 makes the control system complicated. To the contrary, in the system employing the natural circulation of the refrigerant, since no dews are generated even if the rotation frequency of the fans 15C of the concerned evaporator 15 is varied, it is possible to design a simple control system for an abnormal state only utilizing the fan rotational frequency control.

As a preferable specific embodiment of the deviation information detecting means 50 and the fan controlling means 52 included in the apparatus for an operation in an abnormal state having the above described configurations, three embodiments will be described hereinafter.

### (First embodiment of the apparatus for operation in abnormal state)

As shown in Figure 4, the deviation information detecting means 50 includes the above described the plurality of supplied air temperature detecting means 25 and valve opening degree detecting means 54 for detecting the opening degree of the flow regulating valve 20. The fan controlling means 52 is configured to reduce or stop the rotational frequency of the fans 15C if the supplied air temperature is equal to or higher than the upper limit of the specification temperature range of the servers 14, and if the flow regulating valve 20 has an opening degree of approximate maximum. An encoder may be employed as the valve opening degree detecting means 54, for example. Specifically, the valve rotational frequency of each flow regulating valve 20 is detected by the encoder, and the opening degree of approximate maximum may be found based on the valve rotational frequency and the valve opening degree, and the valve opening degree of 70% or more may be defined as the opening degree of approximate maximum, and more preferably valve opening degree of 80% or more, for example.

In the first embodiment, for example, in the case where the specification temperature range of the server 14 is 10 to 30°C, if supplied air temperature exceeds 30°C and the valve opening degree is 70% or more, it may be configured to reduce or stop the rotational frequency of the fans 15C of the evaporator 15.

In this way, when the deviation information detecting means 50 includes not only the plurality of supplied air temperature detecting means 25 but also the valve opening degree detecting means 54, it is possible to prevent the normal operation of the evaporator 15 of interest from being misrecognized as the abnormal operation, so as not to reduce or stop the fans 15C of this evaporator 15. Accordingly, it is possible to precisely detect the lowering of the cooling capacity of the evaporator 15, and control the rotational frequency of the fans 15C in accordance with its cooling capacity.

Specifically, the cooling system 10, in which the refrigerant is naturally circulated as described above, controls the opening degree of the flow regulating valve 20 based on the temperature of the air supplied from the evaporator 15, so as to control the flow rate of the refrigerant flowing in the cooling coil 18, thereby adjusting the temperature of the supplied air supplied from the evaporator 15 to be 25°C, for example. Hence, there is a response lag (time lag) from the adjustment of the valve opening degree until the temperature of the supplied air starts to change. For example, even if the cooling capacity of the evaporator 15 is normal, a temporal increase in temperature of the warm air exhausted from the server 14 causes increase in cooling load of the evaporator 15, the temperature of the supplied air of this evaporator 15 temporarily becomes increased, and exceeds the upper limit of the specification temperature range due to the response lag. In such a situation, if the rotational frequency of the fans 15C of this evaporator 15 is reduced or stopped, the normal operation of this evaporator 15 may be misrecognized as the abnormal operation, so that the rotational frequency of the fans is controlled to be reduced.

### (Second embodiment of the apparatus for operation in abnormal state)

As shown in Figure 5, the deviation information detecting means 50 further includes refrigerant temperature detecting means 56 for detecting the temperature of the refrigerant to be supplied to the cooling coil 18 in addition to the plurality of supplied air temperature detecting means 25 and the valve opening degree detecting means 54 of the first embodiment. The fan controlling means 52 is configured to reduce or stop the rotational frequency of the fans 15C if the supplied air temperature is equal to or higher than the specification temperature range of the servers 14, the flow regulating valve 20 has the approximate maximum opening degree, and the refrigerant temperature is equal to or lower than the design temperature for securing the maximum cooling capacity. The liquid refrigerant temperature sensor 44 for detecting the temperature of the liquid refrigerant is disposed at the exit of the heat exchange coil 28 of the cooling tower 22, as described above, and the refrigerant temperature detecting means 56 is preferably disposed at the entry of each evaporator 15 because some variation (change) in the refrigerant temperature occurs in the fluid pipe 24 between the cooling tower 22 to the evaporator 15.

In the second embodiment of the apparatus for an operation in an abnormal state, since there is further provided the refrigerant temperature detecting means 56 in addition to the plurality of supplied air temperature detecting means 25 and the valve opening degree detecting means 54, it is possible to more precisely monitor the deterioration of the cooling capacity of each evaporator 15. Specifically, although the temperature of the supplied air from the evaporator 15 is equal to or higher than the upper limit of the specification temperature range, and the flow regulating valve 20 has the approximate maximum opening degree, the cooling tower 22 operates normally if the refrigerant temperature is equal to or lower than the design temperature for securing the maximum cooling capacity, and this lowering of the cooling capacity is considered as a temporal variation due to disturbance or the like. Consequently, it may rather cause a wrong control if the rotational frequency of the fans 15C is reduced or stopped in response to the disturbance or the like when the evaporator 15 achieves the maximum cooling capacity.

The temperature of the refrigerant supplied to the evaporator 15 is an index to indicate whether or not the cooling system 10 of the natural circulation type operates normally, and the refrigerant temperature detecting means 56 is provided so as to monitor whether or not there is any abnormality in the entire cooling system 10 of the natural circulation type.

The refrigerant temperature detecting means 56 may be replaced with a refrigerant pressure detecting means (not shown). The refrigerant pressure detecting means may be disposed at any position between the exit of the flow regulating valve 20 and the exit of the evaporator 15.

### (Third embodiment of the apparatus for operation in abnormal state)

As shown in Figure 6, the deviation information detecting means 50 further includes a plurality of intake air temperature detecting means 58 for detecting the intake air temperature of the warm air sucked into the intake ports 15A of each evaporator 15 in addition to the plurality of supplied air temperature detecting means 25 and the valve opening degree detecting means 54 of the first embodiment. The fan controlling means 52 is configured to reduce or stop the rotational frequency of the fans 15C if the supplied air temperature is equal to or higher than the specification temperature range of the servers 14, the flow regulating valve 20 has the approximate maximum opening degree, and the temperature difference between the intake air temperature and the supplied air temperature of the evaporator 15 is equal to or larger than the design temperature difference for securing the maximum cooling capacity.

For example, in the case of the evaporator 15 of interest normally operating, the design temperature difference is 15°C if the evaporator 15 has the cooling capacity to cool the intake air having a temperature of 40°C to a temperature of 25°C for the supplied air. In this case, it is configured to reduce or stop the rotational frequency of the fans 15C if the supplied air temperature becomes equal to or higher than the upper limit of the specification temperature range of the servers 14 and the flow regulating valve 20 has the approximate maximum opening degree, and when the design temperature difference between the intake air temperature and the supplied air temperature becomes equal to or larger than 15°C.

Specifically, it is possible to confirm how much the cooling capacity of each evaporator 15 achieves by monitoring the temperature difference between the intake temperature and the supplied air temperature of each evaporator 15. Hence, even when the supplied air temperature is equal to or higher than the upper limit of the specification temperature range and the valve opening degree is the approximate maximum opening degree, the cooling capacity is sufficient if the temperature difference between the intake temperature and the supplied air temperature is equal to or smaller than the design temperature difference for securing the maximum cooling capacity, and this lowering of the cooling capacity is considered as a temporal variation due to disturbance. Consequently, reduction or stop of the rotational frequency of the fans 15C before the evaporator 15 achieves the maximum cooling capacity may rather cause a wrong control.

According to the embodiment of the present invention, it is possible to securely determine which evaporator 15 has abnormality in the cooling capacity among the plurality of evaporators 15, and prevent the warm air exhausted from the servers 14 from being recirculated in the cooling space, thereby reducing the cooling load of the other evaporator 15 operating normally as well as preventing the deterioration of the thermal environment of the entire server room 12.

In the present embodiment, the servers 14 have been described as an example of electronic equipment. However, the present invention is also applicable to a general cooling system for electronic equipment, for example, such as a semiconductor manufacturing apparatus, which requires precise temperature control and which generates from its own large amount of heat.

### {Reference Signs List}

10: Cooling system, 11: Floor, 12: Server room, 13: Rack, 14: Server, 14A: Suction port, 14B: Exhaust port, 14C: Fan, 15: Evaporator, 15A: Intake port, 15B: Outlet port, 15C: Fan, 16: Unit row, 18: Cooling coil, 20: Flow regulating valve, 21: Warm space, 22: Cooling tower (condenser), 23: Cooling space, 24: Fluid pipe, 24X, 24Y: Branched pipe, 25: Supplied air temperature detecting means, 26: Gas pipe, 26X, 26Y: Branched pipe, 28: Heat exchange coil, 30: Cooling tower main body, 34: Sprinkler, 36: Blower fan, 36A: Air flow volume adjusting means, 42: Controlling mechanism, 44: Liquid refrigerant temperature sensor, 46: Controlling means, 50: Deviation information detecting means, 52: Fan controlling means, 54: Valve opening degree detecting means, 56: Refrigerant temperature detecting means, 58: Intake air temperature detecting means

## Claims

1. An apparatus for operating a cooling system in an abnormal state, wherein the cooling system including:
a plurality of evaporators that suck warm air exhausted from a plurality of electronic equipment installed in an equipment room with fans, cool the warm air through heat exchange with a refrigerant flowing in a cooling coil, and supply cool air into the equipment room; and
a condenser disposed at a position higher than the plurality of evaporators, the condenser which cools the refrigerant circulated naturally between the condenser and each evaporator,
the cooling system which adjusts a supplied air temperature of air supplied from each evaporator by adjusting an opening degree of each flow regulating valve that regulates a flow rate of the refrigerant flowing in the cooling coil,
wherein
the apparatus comprising:
deviation information detecting means for sequentially detecting deviation information between an maximum cooling capacity and a current cooling capacity in operation for each of the plurality of evaporators; and
fan controlling means for reducing or stopping a rotational frequency of a fan for an evaporator which has deviation information exceeding a predefined abnormal determining threshold value among the plurality of evaporators.

2. The apparatus for operating a cooling system in an abnormal state according to claim 1, wherein
the fan controlling means reduces the rotational frequency of the fan in accordance with a cooling capacity lowering rate of the evaporator based on the deviation information, and stops the fan if the cooling capacity lowering rate exceeds a threshold value.

3. The apparatus for operating a cooling system in an abnormal state according to claim 1 or claim 2, wherein
the deviation information detecting means includes: supplied air temperature detecting means for detecting the supplied air temperature; and valve opening degree detecting means for detecting the opening degree of each flow regulating valve, and
the fan controlling means reduces or stops the rotational frequency of the fan if the supplied air temperature is equal to or higher than an upper limit of a specification temperature range of the electronic equipment, and if the flow regulating valve has an approximate maximum opening degree.

4. The apparatus for operating a cooling system in an abnormal state according to claim 3, wherein
the deviation information detecting means further comprises refrigerant temperature detecting means for detecting a temperature of the refrigerant to be supplied to the cooling coil, and
the fan controlling means reduces or stops the rotational frequency of the fan if the supplied air temperature is equal to or higher than the upper limit of the specification temperature range of the electronic equipment, and if the flow regulating valve has the approximate maximum opening degree, and if the refrigerant temperature is equal to or lower than a design temperature for securing the maximum cooling capacity.

5. The apparatus for operating a cooling system in an abnormal state according to claim 3, wherein
the deviation information detecting means further comprises refrigerant pressure detecting means for detecting pressure of the refrigerant to be supplied to the cooling coil, and
the fan controlling means reduces or stops the rotational frequency of the fan if the supplied air temperature is equal to or higher than the upper limit of the specification temperature range of the electronic equipment, and if the flow regulating valve has the approximate maximum opening degree, and if the refrigerant pressure is equal to or higher than a design pressure for securing the maximum cooling capacity.

6. The apparatus for operating a cooling system in an abnormal state according to claim 3, wherein
the deviation information detecting means further comprises intake air temperature detecting means for detecting an intake air temperature of the warm air sucked into the evaporators, and
the fan controlling means reduces or stops the rotational frequency of the fan if the supplied air temperature is equal to or higher than the upper limit of the specification temperature range of the electronic equipment, if the flow regulating valve has the approximate maximum opening degree, and if a temperature difference between the intake air temperature and the supplied air temperature is equal to or larger than a design temperature difference for securing the maximum cooling capacity.

7. The apparatus for operating a cooling system in an abnormal state according to any one of claim 1 to claim 6, wherein
the electronic equipment is housed in racks in a stacked state, and each of the racks has suction ports formed at a front face thereof, and exhaust ports formed at a rear face thereof, and the evaporator is disposed between the racks, and
the intake ports of the evaporators and the exhaust ports of the racks face an identical space to form a warm space, and outlet ports of the evaporators and suction ports of the racks face another identical space to form a cooling space.
